Europäisches Patentamt

European Patent Office

Office européen des brevets

(19)

(11) **EP 1 260 991 A1**

(12) **EUROPEAN PATENT APPLICATION**

(43) Date of publication:
**27.11.2002 Bulletin 2002/48**

(51) Int Cl.⁷: **H01B 3/46**, C08J 9/26,
H01L 21/312, H01L 21/768,
C08J 9/02, C08L 83/04,
H01L 21/316, C09D 183/04

(21) Application number: **02253445.7**

(22) Date of filing: **15.05.2002**

(84) Designated Contracting States:
**AT BE CH CY DE DK ES FI FR GB GR IE IT LI LU
MC NL PT SE TR**
Designated Extension States:
**AL LT LV MK RO SI**

(30) Priority: **23.05.2001 US 293015 P
24.09.2001 US 961808**

(71) Applicant: **Shipley Co. L.L.C.
Marlborough, MA 01752 (US)**

(72) Inventors:
• **Gallagher, Michael K.
Hopkinton, Massachusetts 01748 (US)**

• **Gore, Robert H.
Southampton, Pennsylvani 18966 (US)**
• **Lamola, Angelo A.
Worcester, Pennsylvania 19490 (US)**
• **You, Yujian
Lansdale, Pennsylvania 19446 (US)**

(74) Representative: **Kent, Venetia Katherine
Rohm and Haas (UK) Ltd
European Operations Patent Dept.
Lennig House
2 Mason's Avenue
Croydon, CR9 3NB (GB)**

(54) **Porous materials**

(57)      Porous dielectric materials having low dielectric constants > 30% porosity and a closed cell pore structure are disclosed along with methods of preparing the materials. Such materials are particularly suitable for use in the manufacture of electronic devices.

**Description**

Background of the Invention

This invention relates generally to the field of porous materials. In particular, this invention relates to porous dielectric materials useful in the manufacture of electronic devices.

As electronic devices become smaller, there is a continuing desire in the electronics industry to increase the circuit density in electronic components, such as integrated circuits, circuit boards, multichip modules, chip test devices, and the like, without degrading electrical performance. At the same time, it is desirable to increase the speed of signal propagation in these components. One method of accomplishing these goals is to reduce the dielectric constant of the interlayer, or intermetal, insulating material used in the components. A method for reducing the dielectric constant of such interlayer, or intermetal, insulating material is to incorporate within the insulating film very small, uniformly dispersed pores or voids.

Porous dielectric matrix materials are well-known in the art. One known process of making a porous dielectric involves co-polymerizing a thermally labile monomer with a dielectric monomer to form a block copolymer, followed by heating to decompose the thermally labile monomer unit. See, for example, U.S. Patent No. 5,776,990 (Hedrick et al.). In this approach, the amount of the thermally labile monomer unit is limited to amounts less than about 30% by volume. If more than about 30% by volume of the thermally labile monomer is used, the resulting dielectric material has cylindrical or lamellar domains, instead of pores or voids, which lead to interconnected or collapsed structures upon removal, e.g., heating to degrade the thermally labile monomer unit. See, for example, Carter et. al., *Polyimide Nanofoams from Phase-Separated Block Copolymers,* Electrochemical Society Proceedings, volume 97-8, pages 32-43 (1997). Thus, the block copolymer approach provides only a limited reduction in the dielectric constant of the matrix material.

Dielectric materials for use in integrated circuit manufacture have been reported having up to 30% porosity with closed cells. However, such report failed to describe how to achieve such high porosity while maintaining closed cells, i.e. with no interconnectivity between the pores. Conventional methods of making porous dielectric materials fail to achieve closed cell porosity above 30%. As a result, conventional methods provide porous dielectric materials having 30% porosity with interconnected pores. This pore interconnectivity can lead to degraded electrical performance, such as crosstalk.

Therefore, there is a need for porous dielectric materials having 30% porosity or greater, wherein the pores are not interconnected, particularly for use in the manufacture of electronic devices.

In general, the size and nature of porosity is easy to probe in a solid bulk sample. Typical techniques to probe the pore structure and pore dimensions include nitrogen and mercury porosimetry, xenon nuclear magnetic resonance spectroscopy, and ultrasound. Methods of analyzing particles in solutions and adsorption of gases are outlined in Hemnitz, Principles of Colloid and Surface Chemistry, Marcel Dekker, New York, p 489-544. However, all of these techniques are unsuitable when trying to elucidate the nature of a thin film on a silicon wafer. In this special case the volume of material is too small relative to the weight and mass of the silicon substrate so that these techniques do not effectively probe the pore structure present in the film. Thus new techniques have been applied to this problem such as PALS or SANS which require nuclear reactors to generate the positronium ions or neutron particles respectively and therefore are too expensive and complex for use in a commercial laboratory or manufacturing facility.

Therefore, there is a need for an improved method for determining the interconnectivity of pores in a thin, porous dielectric film.

Summary of the Invention

It has been surprisingly found that porous dielectric materials can be prepared having grater than 30% porosity while maintaining a closed cell pore structure. Nanoporous closed cell films above 30% can be prepared by selecting the pore-forming particle and its particle size.

In a first aspect, the present invention provides a closed cell porous dielectric material suitable for use in electronic device manufacture, the porous dielectric material having greater than or equal to 30% porosity.

In a second aspect, the present invention provides a closed cell porous organo polysilica dielectric film suitable for use in electronic device manufacture, the porous organo polysilica dielectric material having greater than or equal to 30% porosity.

In a third aspect, the present invention provides a method of manufacturing a porous dielectric material suitable for use in electronic device manufacture including the steps of: a) dispersing a plurality of removable polymeric porogen particles in a B-staged dielectric material, b) curing the B-staged dielectric material to form a dielectric matrix material without substantially degrading the porogen particles; c) subjecting the dielectric matrix material to conditions which at least partially remove the porogen to form a porous dielectric material without substantially degrading the dielectric material; wherein the porogen is substantially compatible with the B-staged dielectric material; wherein the dielectric material is ≥ 30% porous; and wherein the mean particle size of the plurality of porogen particles is selected to provide a closed cell pore structure.

In a fourth aspect, the present invention provides a method of manufacturing a porous organo polysilica dielectric material suitable for use in electronic device manufacture including the steps of: a) dispersing a plurality of removable polymeric porogen particles in a B-staged organo polysilica dielectric material, b) curing the B-staged organo polysilica dielectric material to form a dielectric matrix material without substantially degrading the porogen particles; c) subjecting the organo polysilica dielectric matrix material to conditions which at least partially remove the porogen to form a porous dielectric material without substantially degrading the organo polysilica dielectric material; wherein the porogen is substantially compatible with the B-staged organo polysilica dielectric material and wherein the porogen includes as polymerized units at least one compound selected from silyl containing monomers or poly(alkylene oxide) monomers; wherein the dielectric material is ≥ 30% porous; and wherein the mean particle size of the plurality of porogen particles is selected to provide a closed cell pore structure.

In a fifth aspect, the present invention provides a method of preparing an integrated circuit with a closed cell porous film including the steps of: a) depositing on a substrate a layer of a composition including B-staged organo polysilica dielectric material having polymeric porogen dispersed therein; b) curing the B-staged organo polysilica dielectric material to form an organo polysilica dielectric matrix material without substantially removing the porogen; c) subjecting the organo polysilica dielectric matrix material to conditions which at least partially remove the porogen to form a porous organo polysilica dielectric material layer without substantially degrading the organo polysilica dielectric material; d) patterning the porous dielectric layer; e) depositing a metallic film onto the patterned porous dielectric layer; and f) planarizing the film to form an integrated circuit; wherein the porogen is substantially compatible with the B-staged organo polysilica dielectric material and wherein the porogen includes as polymerized units at least one compound selected from silyl containing monomers or poly(alkylene oxide) monomers; and wherein the dielectric material is ≥ 30% porous.

In a sixth aspect, the present invention provides a method of preparing an integrated circuit with a closed cell porous film including the steps of: a) depositing on a substrate a layer of a composition including B-staged dielectric material having a plurality of polymeric porogens dispersed therein; b) curing the B-staged dielectric material to form a dielectric matrix material without substantially removing the porogens; c) subjecting the dielectric matrix material to conditions which at least partially remove the porogens to form a porous dielectric material layer without substantially degrading the dielectric material; d) patterning the porous dielectric layer; e) depositing a metallic film onto the patterned porous dielectric layer; and f) planarizing the film to form an integrated circuit; wherein the porogen is substantially compatible with the B-staged dielectric material; and wherein the dielectric material is ≥ 30% porous; and wherein the mean particle size of the porogens is selected to provide a closed cell pore structure.

In a seventh aspect, the present invention provides an integrated circuit including a porous dielectric material wherein the porous dielectric material ≥ 30% porous; wherein the pores are substantially non-interconnected; and wherein the mean particle size of the pores is selected to provide a closed cell pore structure.

In an eighth aspect, the present invention provides an electronic device including a porous dielectric layer free of an added cap layer, wherein the porous dielectric layer has ≥ 30% porosity.

Brief Description of the Drawing

FIG. 1 illustrates a modified Randles circuit.
FIG. 2 illustrates a test cell for determining the pore structure of porous thin film materials.

Detailed Description of the Invention

As used throughout this specification, the following abbreviations shall have the following meanings, unless the context clearly indicates otherwise: °C = degrees centigrade; μm = micron; UV = ultraviolet; ppm = parts per million; nm = nanometer; S/m = Siemens per meter; g = gram; wt% = weight percent; Hz = herz; kHz = kiloherz; mV = millivolts; MIAK = methyl iso-amyl ketone; MIBK = methyl iso-butyl ketone; PMA = poly(methyl acrylate); CyHMA = cyclohexylmethacrylate; EG = ethylene glycol; DPG = dipropylene glycol; DEA = diethylene glycol ethyl ether acetate; BzA = benzylacrylate; BzMA = benzyl methacrylate; MAPS = MATS = (trimethoxylsilyl)propylmethacrylate; PETTA = pentacrythriol tetra/triacetate; PPG4000DMA = polypropyleneglycol 4000 dimethacrylate; DPEPA = dipentaerythriol pentaacrylate; TMSMA = trimethylsilyl methacrylate; MOPTSOMS = methacryloxypropylbis(trimethylsiloxy)methylsilane; MOPMDMOS = 3-methacryloxypropylmethyldimethoxysilane; TAT = triallyl-1,3,5-triazine-2,4,6-(1H,3H,5H)-trione; IBOMA isobornyl methacrylate; PGMEA = propyleneglycol monomethylether acetate; and PGDMA = propyleneglycol dimethacrylate; PPODMMST = poly(propylene oxide), bis(dimethoxymethylsilyl); TMOPTMA =trimethylolpropane trimethacrylate; TMOPTA = trimethylolpropane triacrylate; BPEPDMS = bis polyetherpolydimethylsilane; PPGMEA260 = poly(propylene glycol) methyl ether acrylate having a molecular weight of about 260; PPGMEA475 = poly(propylene glycol) methyl ether acrylate having a molecular weight of about 475; VTMS = vinyltrimethylsilane; and VTMOS = vinyltrimethoxysilane.

The term "(meth)acrylic" includes both acrylic and methacrylic and the term "(meth)acrylate" includes both acrylate and methacrylate. Likewise, the term "(meth)acrylamide" refers to both acrylamide and methacrylamide. "Alkyl" includes straight chain, branched and cyclic alkyl groups. The term "porogen" refers to a pore forming material, that is a polymeric material or particle dispersed in a dielectric material that is subsequently removed to yield pores, voids or free volume in the dielectric material. Thus, the terms "removable porogen," "removable polymer" and "removable particle" are used interchangeably throughout this specification. The terms "pore," "void" and "free volume" are used interchangeably throughout this specification. "Cross-linker" and "cross-linking agent" are used interchangeably throughout this specification, "Polymer" refers to polymers and oligomers. The term "polymer" also includes homopolymers and copolymers. The terms "oligomer" and "oligomeric" refer to dimers, trimers, tetramers and the like. "Monomer" refers to any ethylenically or acetylenically unsaturated compound capable of being polymerized. Such monomers may contain one or more double or triple bonds.

The term "B-staged" refers to uncured dielectric matrix materials. By "uncured" is meant any material that can be polymerized or cured, such as by condensation, to form higher molecular weight materials, such as coatings or films. Such B-staged material may be monomeric, oligomeric or mixtures thereof. B-staged material is further intended to include mixtures of polymeric material with monomers, oligomers or a mixture of monomers and oligomers. The dielectric films described herein are described as either the polymerized or cured materials, or as the monomer units or oligomers used to prepare such polymerized or cured dielectric films.

"Halo" refers to fluoro, chloro, bromo and iodo. Likewise, "halogenated" refers to fluorinated, chlorinated, brominated and iodinated. Unless otherwise noted, all amounts are percent by weight and all ratios are by weight. All numerical ranges are inclusive and combinable.

The present invention relates to porous dielectric materials having a closed cell pore structure and $\geq$ 30% porosity. Such porous materials are useful in the fabrication of electronic and optoelectronic devices.

Thus, the present invention provides a closed cell porous dielectric material suitable for use in electronic device manufacture, the porous dielectric material having greater than or equal to 30% porosity. A wide variety of dielectric materials may be used in the present invention. Suitable dielectric materials include, but are not limited to: inorganic matrix materials such as carbides, oxides, nitrides and oxyfluorides of silicon, boron, or aluminum; silicones; siloxanes, such as silsesquioxanes; organo polysilica materials; silicates; silazanes; and organic matrix materials such as benzocyclobutenes, poly(aryl esters), poly(ether ketones), polycarbonates, polyimides, fluorinated polyimides, polynorbornenes, poly(arylene ethers), polyaromatic hydrocarbons, such as polynaphthalene, polyquinoxalines, poly(perfluorinated hydrocarbons) such as poly(tetrafluoroethylene), and polybenzoxazoles. Particularly suitable dielectric materials are those available under the tradenames TEFLON, SILK, AVATREL, BCB, AEROGEL, XEROGEL, PARYLENE F, and PARYLENE N.

Suitable organo polysilica materials are those including silicon, carbon, oxygen and hydrogen atoms and having the formula:

$$((RR^1SiO)_n(R^2SiO_{1.5})_b(R^3SiO_{1.5})_c(SiO_2)_d)_n$$

wherein R, $R^1$, $R^2$ and $R^3$ are independently selected from hydrogen, $(C_1$-$C_6)$alkyl, aryl, and substituted aryl; a, c and d are independently a number from 0 to 1; b is a number from 0.2 to 1; n is integer from about 3 to about 10,000; provided that a + b + c + d = 1; and provided that at least one of R, $R^1$ and $R^2$ is not hydrogen. "Substituted aryl" refers to an aryl group having one or more of its hydrogens replaced by another substituent group, such as cyano, hydroxy, mercapto, halo, $(C_1$-$C_6)$alkyl, $(C_1$-$C_6)$alkoxy, and the like. In the above formula, a, b, c and d represent the mole ratios of each component. Such mole ratios can be varied between 0 and about 1. It is preferred that a is from 0 to about 0.8. It is also preferred that c is from 0 to about 0.8. It is further preferred that d is from 0 to about 0.8. In the above formula, n refers to the number of repeat units in the B-staged material. Preferably, n is an integer from about 3 to about 1000. It will be appreciated that prior to any curing step, the B-staged organo polysilica dielectric matrix materials may include one or more of hydroxyl or alkoxy end capping or side chain functional groups. Such end capping or side chain functional groups are known to those skilled in the art.

Suitable organo polysilica dielectric matrix materials include, but are not limited to, silsesquioxanes, partially condensed halosilanes or alkoxysilanes such as partially condensed by controlled hydrolysis of tetraethoxysilane having number average molecular weight of about 500 to about 20,000, organically modified silicates having the composition $RSiO_3$ or $R_2SiO_2$ wherein R is an organic substituent, and partially condensed orthosilicates having $Si(OR)_4$ as the monomer unit. Silsesquioxanes are polymeric silicate materials of the type $RSiO_{1.5}$ where R is an organic substituent. Suitable silsesquioxanes are alkyl silsesquioxanes such as methyl silsesquioxane, ethyl silsesquioxane, propyl silsesquioxane, butyl silsesquioxane and the like; aryl silsesquioxanes such as phenyl silsesquioxane and tolyl silsesquioxane; alkyl/aryl silsesquioxane mixtures such as a mixture of methyl silsesquioxane and phenyl silsesquioxane; and mixtures of alkyl silsesquioxanes such as methyl silsesquioxane and ethyl silsesquioxane. B-staged silsesquioxane materials include homopolymers of silsesquioxanes, copolymers of silsesquioxanes or mixtures thereof. Such dielectric materials are generally commercially available or may be prepared by known methods.

It is preferred that the organo polysilica is a silsesquioxane, and more preferably methyl silsesquioxane, ethyl silsesquioxane, propyl silsesquioxane, iso-butyl silsesquioxane, tert-butyl silsesquioxane, phenyl silsesquioxane or mixtures thereof. Particularly useful silsesquioxanes include mixtures of hydrido silsesquioxanes with alkyl, aryl or alkyl/aryl silsesquioxanes. Other particularly useful silsesquioxanes include combinations of alkyl or aryl silsesquioxanes with tetra($C_1$-$C_6$)alkylorthosilicates such as tetraethylorthosilicate, or copolymers or composites thereof. Exemplary combinations of alkyl silsesquioxanes with tetra($C_1$-$C_6$)alkylorthosilicate are disclosed in U.S. Patent No. 4,347,609 (Fukuyama et al.). Also suitable are cohydrolysates of tetra($C_1$-$C_6$)alkylorthosilicates or silicon tetrachloride with a compound of the formula $RSiX_3$, wherein R is selected from ($C_1$-$C_6$)alkyl or aryl; and X is selected from halo, ($C_1$-$C_4$)alkoxy or acyloxy. Typically, the silsesquioxanes useful in the present invention are used as oligomeric materials, generally having from about 3 to about 10,000 repeating units.

Other suitable silsesquioxane compositions include, but arc not limited to: hydrogen silsesquioxane, alkyl silsesquioxane such as methyl silsesquioxane, aryl silsesquioxane such as phenyl silsesquioxane, and mixtures thereof, such as alkyl/hydrogen, aryl/hydrogen, alkyl/aryl silsesquioxane or alkyl/aryl/hydrido silsesquioxane. It is preferred that the dielectric material comprises a silsesquioxane, more preferably a combination of a silsesquioxane with a tetra ($C_1$-$C_6$)alkylorthosilicates, and still more preferably a combination of methyl silsesquioxane with tetraethylorthosilicate.

Also provided by the present invention is a closed cell porous organo polysilica dielectric film suitable for use in electronic device manufacture, the porous organo polysilica dielectric film having greater than or equal to 30% porosity. The present invention further provides a closed cell porous film comprising hydrogen silsesquioxane as monomer units for use in electronic device manufacture, the porous film having greater than or equal to 30% porosity.

It will be appreciated that a mixture of dielectric materials may be used, such as two or more organo polysilica dielectric materials or a mixture of an organo polysilica dielectric matrix material with one or more other dielectric matrix materials, i.e. not an organo polysilica dielectric matrix material. Suitable other dielectric matrix materials include, but are not limited to, inorganic matrix materials such as carbides, oxides, nitrides and oxyfluorides of silicon, boron, or aluminum; and organic matrix materials such as benzocyclobutenes, poly(aryl esters), poly(ether ketones), polycarbonates, polyimides, fluorinated polyimides, polynorbornenes, poly(arylene ethers), polyaromatic hydrocarbons, such as polynaphthalene, polyquinoxalines, poly(perfluorinated hydrocarbons) such as poly(tetrafluoroethylene), and polybenzoxazoles.

It is preferred that when a mixture of an organo polysilica dielectric matrix material and another dielectric matrix material is used, the organo polysilica dielectric matrix material is present as a predominant component. It is further preferred that the organo polysilica dielectric matrix material in such admixtures is methyl silsesquioxane, phenyl silsesquioxane or mixtures thereof.

Porous dielectric materials having a wide variety of porosities can be prepared according to the present invention. Typically, the porous materials have a porosity of $\geq 30\%$ by volume, preferably $\geq 35\%$, more preferably $\geq 40\%$, and even more preferably $\geq 45\%$. Porosities of 50% can also be achieved according to the present invention. Such porosity is a measure of the total volume of pores in the dielectric material.

The pore structure of the porous thin film dielectric materials of the present invention can be determined by a variety of methods. Preferably, an electrochemical test is used to measure an electrical property of the material, such as impedance, conductivity and the like. Particularly suitable is electrochemical impedance spectroscopy ("EIS").

Dielectric films typically have a very high impedance. When the film matrix contains open channels, a decrease in impedance is recorded as solvent and ions penetrate the film. When monitored by EIS, these phenomena can evaluate the porosity of the dielectric film.

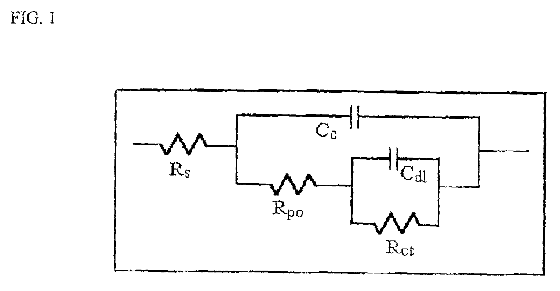

In an EIS experiment, a variable frequency alternating current ("AC") potential is applied to a system and the current is measured. The response follows Ohm's law, $(E = IZ)$ where the current ("I") and the impedance ("Z") are represented by complex numbers. The frequency-independent impedance is related to resistance ("R") and the frequency-dependent impedance is related to capacitance ("C"), When the data are computer modeled, a modified Randles circuit adequately describes the sample's behavior. A suitable Randles circuit is shown in FIG. 1, where $R_{ct}$ is the resistance for the charge transfer and $C_{dl}$ is the double layer capacitance. This model accounts for electrode interfacial reactions ("$\overset{\backsim}{R}_s$") as well as the sample's resistance ("$R_{po}$") and sample's capacitance ("$C_c$").

This $R_{po}$ resistance is an indication of the rate of mass transport of ions into ionically conducting low resistive channels in the film. Values of $R_{po}$ are, therefore, related to the film's ionic conductivity, according to the formula

$$R_{po} = \rho d = (\sigma)^{-1} = (\mu\ c\ n\ z)^{-1}$$

where $\rho$ is resistivity, d is electrode separation distance, $\sigma$ is conductance, $\mu$ is mobility, c is the charge on an electron, n is the number of electrons, and z is charge on an ion.

A capacitor is formed when a non-conducting media separates two conducting plates. In the case of a doped silicon wafer, coated with a dielectric, and immersed in solution, the wafer is one plate, the film is the non-conducting media, and the solution is the second plate. The capacitance of this system is dependent on solvent penetration into the film. In the case of water, the large difference between the dielectric constant of water (78) and that of the non-conducting film (1.1-4.1) results in changes to $C_c$ reflecting changes in the dielectric constant of the film. Changes in $C_c$ reflect changes in the dielectric constant of the sample according to the formula

$$C_c = (\varepsilon \varepsilon_o / d)\ A$$

where $\varepsilon$ is the dielectric constant, $\varepsilon_o$ is the permittivity of free space, and A is the electrode area.

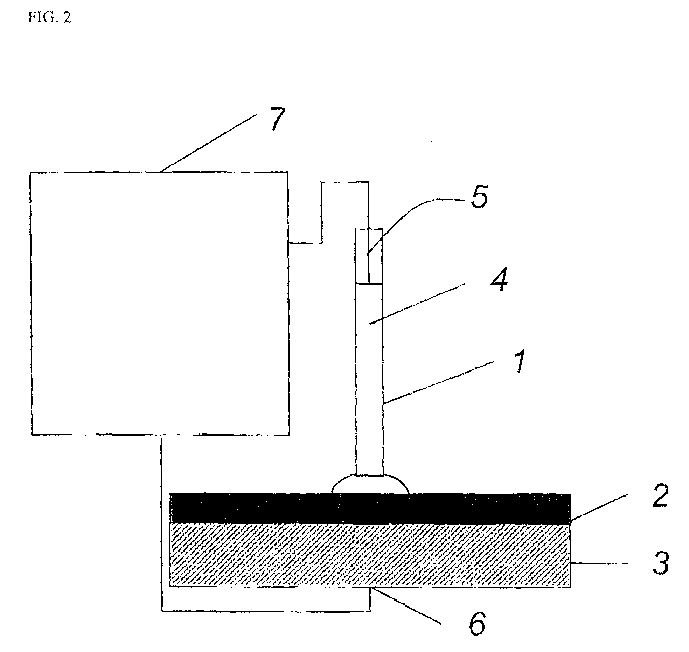

Referring to FIG. 2, the pore interconnectivity of a porous dielectric film is measured by placing a glass ball joint **1**, such as a PYREX™ glass ball, along with a rubber o-ring against the thin, porous dielectric layer **2** deposited onto a conductive silicon wafer **3**. The resistivity ("R") of such a conductive silicon wafer is typically <0.02 Ohm-cm. The ball joint is held in place by a fastening means, such as a clamp, and an aqueous reference standard solution **4** is charged into the ball joint. Suitable reference solutions include, but are not limited to a 10,000 ppm of copper (as copper nitrate) ICP standard solution in 5% nitric acid or 0.1 molar copper chloride in water. A platinum electrode **5** is placed into the reference solution and then a second reference electrode is also inserted into the solution. The back side of the wafer, i.e. the side opposite the film, is also contacted with an electrode **6.** A measuring or monitoring system **7** is used to record an electrical measurement, such as impedance, capacitance, leakage current and the like. When measuring impedance, a suitable measuring system is a Solartron 1260 Gain/Phase Analyzer, EG&G Princeton Applied Research (PAR) 273 potentiostat/Galvanostat, and Zplot Impedance Software (available from Scribner Associates) used to measure impedance. Individual data files collected are fitted to a modified Randles circuit, (Zsim Impedance software from Scribner Associates), and their impedance parameters are plotted and compared as a function of time.

The reference standard solution is allowed to remain in contact with the film for 24 hours and the impedance is measured again. The values are compared to those for a film of the same composition that is non-porous. Differences in conductivity values of less than 1 S/m, as determined using the EIS method, indicate closed cell pore structures. Differences in conductivity values of greater than 1 S/m, as determined using the EIS method, indicate open cell pore structures.

One of the advantages of the present invention is that the porous dielectric materials have closed cell pore structures. By "closed cell" pore structures, it is meant that the pores within the porous dielectric material are substantially non-interconnected, and preferably are not interconnected. By "substantially" non-interconnected it is meant that less than 10%, preferably less than 5%, and more preferably less than 2% of the pores are interconnected.

The high levels of porosity and the closed cell pore structures of the present porous dielectric materials are achieved by selecting porogens that are substantially compatible with the dielectric material and that have a mean particle size such that a closed cell pore structure is obtained.

By "compatible" it is meant that a composition of B-staged dielectric material and porogen are optically transparent to visible light. It is preferred that a solution of B-staged dielectric material and porogen, a film or layer including a composition of B-staged dielectric material and porogen, a composition including a dielectric matrix material having porogen dispersed therein, and the resulting porous dielectric material after removal of the porogen are all optically transparent to visible light. By "substantially compatible" it is meant that a composition of B-staged dielectric material and porogen is slightly cloudy or slightly opaque. Preferably, "substantially compatible" means at least one of a solution of B-staged dielectric material and porogen, a film or layer including a composition of B-staged dielectric material and porogen, a composition including a dielectric matrix material having porogen dispersed therein, and the resulting porous dielectric material after removal of the porogen is slightly cloudy or slightly opaque.

To be compatible, the porogen must be soluble or miscible in the B-staged dielectric material, in the solvent used to dissolve the B-staged dielectric material or both. When a film or layer of a composition including the B-staged dielectric material, porogen and solvent is cast, such as by spin casting, much of the solvent evaporates. After such film casting, the porogen must be soluble in the B-staged dielectric material so that it remains substantially uniformly dispersed. If the porogen is not compatible, phase separation of the porogen from the B-staged dielectric material occurs and large domains or aggregates form, resulting in an increase in the size and non-uniformity of pores. Such compatible porogens provide cured dielectric materials having substantially uniformly dispersed pores having substantially the same sizes as the porogen particles. Thus, the mean diameter of the resulting pores is substantially the same as the mean particle size of the porogen used to form the pores.

The compatibility of the porogens and dielectric matrix material is typically determined by a matching of their solubility parameters, such as the Van Krevelen parameters of delta h and delta v. See, for example, Van Krevelen et

al., <u>Properties of Polymers. Their Estimation and Correlation with Chemical Structure,</u> Elsevier Scientific Publishing Co., 1976; Olabisi et al., <u>Polymer-Polymer Miscibility</u>, Academic Press, NY, 1979; Coleman et al., <u>Specific Interactions and the Miscibility of Polymer Blends,</u> Technomic, 1991; and A. F. M. Barton, <u>CRC Handbook of Solubility Parameters and Other Cohesion Parameters</u>, 2$^{nd}$ Ed., CRC Press, 1991. Delta h is a hydrogen bonding parameter of the material and delta v is a measurement of both dispersive and polar interaction of the material. Such solubility parameters may either be calculated, such as by the group contribution method, or determined by measuring the cloud point of the material in a mixed solvent system consisting of a soluble solvent and an insoluble solvent. The solubility parameter at the cloud point is defined as the weighted percentage of the solvents. Typically, a number of cloud points are measured for the material and the central area defined by such cloud points is defined as the area of solubility parameters of the material.

When the solubility parameters of the porogen and dielectric matrix material are substantially similar, the porogen will be compatible with the dielectric matrix material and phase separation and/or aggregation of the porogen is less likely to occur. It is preferred that the solubility parameters, particularly delta h and delta v, of the porogen and dielectric matrix material are substantially matched. It will be appreciated by those skilled in the art that the properties of the porogen that affect the porogen's solubility also affect the compatibility of that porogen with the B-staged dielectric material. It will be further appreciated by those skilled in the art that a porogen may be compatible with one B-staged dielectric material, but not another. This is due to the difference in the solubility parameters of the different B-staged dielectric materials,

The compatible, i.e., optically transparent, compositions of the present invention do not suffer from agglomeration or long range ordering of porogen materials, i.e. the porogen is substantially uniformly dispersed throughout the B-staged dielectric material. Thus, the porous dielectric materials resulting from removal of the porogen have substantially uniformly dispersed pores. Such substantially uniformly dispersed, very small pores are very effective in reducing the dielectric constant of the dielectric materials.

The porogens used to form the present highly porous dielectric materials have a particle size selected to maintain a closed cell structure at a given porosity. Too small a pore size may result in an open cell, or interconnected, pore structure for a give porosity of the dielectric material. A porogen having a particular particle size that provides a closed cell structure at 30% porosity may provide an open cell pore structure at higher levels of porosity. For example, for porous dielectric materials having $\geq$ 30% porosity, the porogens must have a particle size greater than 2,5 nm. For 30% porosity, it is preferred that the porogen has a particle size $\geq$ 2.75 nm, and preferably $\geq$ 3 nm. Typically, for dielectric materials having a porosity of 30% to 35%, a porogen having a particle size in the range of 2,75 to 4 nm is selected, and preferably 3 to 3.5 nm. For dielectric materials having a porosity of 35% to 40%, a porogen having a particle size in the range of 3.5 to 8 nm, and preferably 4 to 7 nm, is selected. For dielectric materials having a porosity of 40% to 45%, a porogen having a particle size in $\geq$ 5 nm is selected, preferably 5 to 15 nm, more preferably 5 to 11 nm, and even more preferably 5 to 7 nm. If the size of the porogen is too large, the resulting pores in the dielectric material will be too large to be suitable for advanced electronic devices having very narrow linewidths. Thus, there is an optimum range of pore sizes useful for providing porous dielectric materials having closed cell pore structures.

A wide variety of porogens are suitable for use in the present invention. The porogen polymers are typically cross-linked particles and have a molecular weight and particle size suitable for use as a modifier in advanced interconnect structures in electronic devices. Typically, the useful particle size range for such applications is up to about 100 nm, such as that having a mean particle size in the range of about 0.5 to about 100 nm. However, for the present closed cell porous dielectric materials, it is preferred that the mean particle size is in the range of about 2.75 to about 20 nm, more preferably from about 3 to about 15 nm, and most preferably from about 3 nm to about 10 nm. An advantage of the present process is that the size of the pores formed in the dielectric matrix are substantially the same size, i.e., dimension, as the size of the removed porogen particles used. Thus, the porous dielectric material made by the process of the present invention has substantially uniformly dispersed pores with substantially uniform pore sizes having a mean pore size in the range of from 2.75 to 20 nm, preferably 3 to 15 nm, and more preferably 3 and 10 nm.

The polymers suitable for use as porogens in the present invention are derived from ethylenically or acetylenically unsaturated monomers and are removable, such as by the unzipping of the polymer chains to the original monomer units which are volatile and diffuse readily through the host matrix material. By "removable" is meant that the polymer particles depolymerize, degrade or otherwise break down into volatile components which can then diffuse through the host dielectric matrix film. Suitable unsaturated monomers include, but are not limited to: (meth)acrylic acid, (meth)acrylamides, alkyl (meth)acrylates, alkenyl (meth)acrylates, aromatic (meth)acrylates, vinyl aromatic monomers, nitrogen-containing compounds and their thio-analogs, and substituted ethylene monomers.

Typically, the alkyl (meth)acrylates useful in the present invention are ($C_1$-$C_{24}$) alkyl (meth)acrylates. Suitable alkyl (meth)acrylates include, but are not limited to, "low cut" alkyl (meth)acrylates, "mid cut" alkyl (meth)acrylates and "high cut" alkyl (meth)acrylates.

"Low cut" alkyl (meth)acrylates are typically those where the alkyl group contains from 1 to 6 carbon atoms. Suitable low cut alkyl (meth)acrylates include, but are not limited to: methyl methacrylate ("MMA"), methyl acrylate, ethyl acrylate, propyl methacrylate, butyl methacrylate ("BMA"), butyl acrylate ("BA"), isobutyl methacrylate ("IBMA"), hexyl methacrylate, cyclohexyl methacrylate, cyclohexyl acrylate and mixtures thereof.

"Mid cut" alkyl (meth)acrylates are typically those where the alkyl group contains from 7 to 15 carbon atoms. Suitable mid cut alkyl (meth)acrylates include, but are not limited to: 2-ethylhexyl acrylate ("EHA"), 2-ethylhexyl methacrylate, octyl methacrylate, decyl methacrylate, isodecyl methacrylate ("IDMA", based on branched $(C_{10})$alkyl isomer mixture), undecyl methacrylate, dodecyl methacrylate (also known as lauryl methacrylate), tridecyl methacrylate, tetradecyl methacrylate (also known as myristyl methacrylate), pentadecyl methacrylate and mixtures thereof. Particularly useful mixtures include dodecyl-pentadecyl methacrylate ("DPMA"), a mixture of linear and branched isomers of dodecyl, tridecyl, tetradecyl and pentadecyl methacrylates; and lauryl-myristyl methacrylate ("LMA").

"High cut" alkyl (meth)acrylates are typically those where the alkyl group contains from 16 to 24 carbon atoms. Suitable high cut alkyl (meth)acrylates include, but are not limited to: hexadecyl methacrylate, heptadecyl methacrylate, octadecyl methacrylate, nonadecyl methacrylate, cosyl methacrylate, eicosyl methacrylate and mixtures thereof. Particularly useful mixtures of high cut alkyl (meth)acrylates include, but are not-limited to: cetyl-eicosyl methacrylate ("CEMA"), which is a mixture of hexadecyl, octadecyl, cosyl and eicosyl methacrylate; and cetyl-stcaryl methacrylate ("SMA"), which is a mixture of hexadecyl and octadecyl methacrylate.

The mid-cut and high-cut alkyl (meth)acrylate monomers described above are generally prepared by standard esterification procedures using technical grades of long chain aliphatic alcohols, and these commercially available alcohols are mixtures of alcohols of varying chain lengths containing between 10 and 15 or 16 and 20 carbon atoms in the alkyl group. Examples of these alcohols are the various Ziegler catalyzed ALFOL alcohols from Vista Chemical company, i.e., ALFOL 1618 and ALFOL 1620, Ziegler catalyzed various NEODOL alcohols from Shell Chemical Company, i.e. NEODOL 25L, and naturally derived alcohols such as Proctor & Gamble's TA-1618 and CO-1270, Consequently, for the purposes of this invention, alkyl (meth)acrylate is intended to include not only the individual alkyl (meth)acrylate product named, but also to include mixtures of the alkyl (meth)acrylates with a predominant amount of the particular alkyl (meth)acrylate named.

The alkyl (meth)acrylate monomers useful in the present invention may be a single monomer or a mixture having different numbers of carbon atoms in the alkyl portion. Also, the (meth)acrylamide and alkyl (meth)acrylate monomers useful in the present invention may optionally be substituted. Suitable optionally substituted (meth)acrylamide and alkyl (meth)acrylate monomers include, but are not limited to; hydroxy $(C_2-C_6)$alkyl (meth)acrylates, dialkylamino$(C_2-C_6)$-alkyl(meth)acrylates, dialkylamino$(C_2-C_6)$alkyl (meth)acrylamides.

Particularly useful substituted alkyl (meth)acrylate monomers are those with one or more hydroxyl groups in the alkyl radical, especially those where the hydroxyl group is found at the β-position (2-position) in the alkyl radical. Hydroxyalkyl (meth)acrylate monomers in which the substituted alkyl group is a $(C_2-C_6)$alkyl, branched or unbranched, are preferred. Suitable hydroxyalkyl (meth)acrylate monomers include, but are not limited to: 2-hydroxyethyl methacrylate ("HEMA"), 2-hydroxycthyl acrylate ("HEA"), 2-hydroxypropyl methacrylate, 1-methyl-2-hydroxyethyl methacrylate, 2-hydroxy-propyl acrylate, 1-methyl-2-hydroxyethyl acrylate, 2-hydroxybutyl methacrylate, 2-hydroxybutyl acrylate and mixtures thereof. The preferred hydroxyalkyl (meth)acrylate monomers are HEMA, 1-methyl-2-hydroxyethyl methacrylate, 2-hydroxypropyl methacrylate and mixtures thereof. A mixture of the latter two monomers is commonly referred to as "hydroxypropyl methacrylate" or "HPMA."

Other substituted (meth)acrylate and (meth)acrylamide monomers useful in the present invention are those with a dialkylamino group or dialkylaminoalkyl group in the alkyl radical. Examples of such substituted (meth)acrylates and (meth)acrylamides include, but are not limited to: dimethylaminoethyl methacrylate, dimethylaminoethyl acrylate, N,N-dimethylaminoethyl methacrylamide, N,N-dimethyl-aminopropyl methacrylamide, N,N-dimethylaminobutyl methacrylamide, N,N-di-ethylaminoethyl methacrylamide, N,N-diethylaminopropyl methacrylamide, N,N-diethylaminobutyl methacrylamide, N-(1,1-dimethyl-3-oxobutyl) acrylamide, N-(1,3-diphenyl-1-ethyl-3-oxobutyl) acrylamide, N-(1-methyl-1-phenyl-3-oxobutyl) methacrylamide, and 2-hydroxyethyl acrylamide, N-methacrylamide of aminoethyl ethylene urea, N-methacryloxy ethyl morpholine, N-maleimide of dimethylaminopropylamine and mixtures thereof.

Other substituted (meth)acrylate monomers useful in the present invention are silicon-containing monomers such as γ-propyl tri$(C_1-C_6)$alkoxysilyl (meth)acrylate, γ-propyl tri$(C_1-C_6)$alkylsilyl (meth)acrylate, γ-propyl di$(C_1-C_6)$alkoxy$(C_1-C_6)$alkylsilyl (meth)acrylate, γ-propyl di$(C_1-C_6)$alkyl$(C_1-C_6)$alkoxysilyl (meth)acrylate, vinyl tri$(C_1-C_6)$alkoxysilyl (meth)acrylate, vinyl di$(C_1-C_6)$alkoxy$(C_1-C_6)$alkylsilyl (meth)acrylate, vinyl $(C_1-C_6)$alkoxydi$(C_1-C_6)$alkylsilyl (meth)acrylate, vinyl tri$(C_1-C_6)$alkylsilyl (meth)acrylate, and mixtures thereof.

The vinylaromatic monomers useful as unsaturated monomers in the present invention include, but are not limited to: styrene ("STY"), α-methylstyrene, vinyltoluene, p-methylstyrene, ethylvinylbenzene, vinylnaphthalene, vinylxylenes, and mixtures thereof. The vinylaromatic monomers also include their corresponding substituted counterparts, such as halogenated derivatives, i.e., containing one or more halogen groups, such as fluorine, chlorine or bromine; and nitro, cyano, $(C_1-C_{10})$alkoxy, halo$(C_1-C_{10})$alkyl, carb$(C_1-C_{10})$alkoxy, carboxy, amino, $(C_1-C_{10})$alkylamino derivatives and the like.

The nitrogen-containing compounds and their thio-analogs useful as unsaturated monomers in the present invention include, but are not limited to: vinylpyridines such as 2-vinylpyridine or 4-vinylpyridine; lower alkyl ($C_1$-$C_8$) substituted N-vinyl pyridines such as 2-mcthyl-5-vinyl-pyridine, 2-ethyl-5-vinylpyridine, 3-methyl-5-vinylpyridine, 2,3-dimethyl-5-vinyl-pyridine, and 2-methyl-3-ethyl-5-vinylpyridine; methyl-substituted quinolines and isoquinolines; N-vinylcaprolactam; N-vinylbutyrolactam; N-vinylpyrrolidone; vinyl imidazole; N-vinyl carbazole; N-vinyl-succinimide; (meth)acrylonitrile; o-, m-, or p-aminostyrene; maleimide; N-vinyl-oxazolidone; N,N-dimethyl aminocthyl-vinyl-ether; ethyl-2-cyano acrylate; vinyl acctonitrile; N-vinylphthalimide; N-vinyl-pyrrolidones such as N-vinyl-thio-pyrrolidone, 3 methyl-1-vinyl-pyrrolidone, 4-methyl-1-vinyl-pyrrolidone, 5-methyl-1-vinyl-pyrrolidone, 3-ethyl-1-vinyl-pyrrolidone, 3-butyl-1-vinyl-pyrrolidone, 3,3-dimethyl-1-vinyl-pyrrolidone, 4,5-dimethyl-1-vinyl-pyrrolidone, 5,5-dimethyl-1-vinyl-pyrrolidone, 3,3,5-trimethyl-1-vinyl-pyrrolidone, 4-ethyl-1-vinyl-pyrrolidone, 5-methyl-5-ethyl-1-vinyl-pyrrolidone and 3,4,5-trimethyl-1-vinyl-pyrrolidone; vinyl pyrroles; vinyl anilines; and vinyl piperidines.

The substituted ethylene monomers useful as unsaturated monomers is in the present invention include, but are not limited to: vinyl acetate, vinyl formamide, vinyl chloride, vinyl fluoride, vinyl bromide, vinylidene chloride, vinylidene fluoride and vinylidene bromide.

When the dielectric material is an organo polysilica material, it is preferred that polymeric porogens include as polymerized units at least one compound selected from silyl containing monomers or poly(alkylene oxide) monomers. Such silyl containing monomers or poly(alkylene oxide) monomers may be used to form the uncrosslinked polymer, used as the crosslinker, or both. Any monomer containing silicon may be useful as the silyl containing monomers in the present invention. The silicon moiety in such silyl containing monomers may be reactive or unreactive. Exemplary "reactive" silyl containing monomers include those containing one or more alkoxy or acetoxy groups, such as, but not limited to, trimethoxysilyl containing monomers, triethoxysilyl containing monomers, methyl dimethoxysilyl containing monomers, and the like. Exemplary "unreactive" silyl containing monomers include those containing alkyl groups, aryl groups, alkenyl groups or mixtures thereof, such as but are not limited to, trimethylsilyl containing monomers, triethylsilyl containing monomers, phenyldimethylsilyl containing monomers, and the like. Polymeric porogens including silyl containing monomers as polymerized units are intended to include such porogens prepared by the polymerization of a monomer containing a silyl moiety. It is not intended to include a linear polymer that contains a silyl moiety only as end capping units.

Suitable silyl containing monomers include, but are not limited to, vinyltrimethylsilane, vinyltriethylsilane, vinyltrimethoxysilane, vinyltriethoxysilane, γ-trimethoxysilylpropyl (meth)acrylate, divinylsilane, trivinylsilane, dimethyldivinylsilane, divinylmethylsilane, methyltrivinylsilane, diphenyldivinylsilane, divinylphenylsilane, trivinylphenylsilane, divinylmethylphenylsilane, tetravinylsilane, dimethylvinyldisiloxane, poly(methylvinylsiloxane), poly(vinylhydrosiloxane), poly(phenylvinylsiloxane), allyloxy-tert-butyldimethylsilane, allyloxytrimethylsilane, allyltriethoxysilane, allyltri-iso-propylsilane, allyltrimethoxysilane, allyltrimethylsilane, allyltriphenylsilane, diethoxy methylvinylsilane, diethyl methylvinylsilane, dimethyl ethoxyvinylsilane, dimethyl phenylvinylsilane, ethoxy diphenyrvinylsilane, methyl bis(trimcthylsilyloxy)vinylsilane, triacetoxyvinylsilane, triethoxyvinylsilane, triethylvinylsilane, triphenylvinylsilane, tris(trimethylsilyloxy)vinylsilane, vinyloxytrimethylsilane and mixtures thereof.

The amount of siliyl containing monomer useful to form the porogens of the present invention is typically from about 1 to about 99 %wt, based on the total weight of the monomers used. It is preferred that the silyl containing monomers are present in an amount of from 1 to about 80 %wt, and more preferably from about 5 to about 75 %wt.

Suitable poly(alkylene oxide) monomers include, but are not limited to, poly(propylene oxide) monomers, poly (ethylene oxide) monomers, poly(ethylene oxide/propylene oxide) monomers, poly(propylene glycol) (meth)acrylates, poly(propylene glycol) alkyl ether (meth)acrylates, poly(propylene glycol) phenyl ether (meth)acrylates, poly(propylene glycol) 4-nonylphenol ether (meth)acrylates, poly(ethylene glycol) (meth)acrylates, poly(ethylene glycol) alkyl ether (meth)acrylates, poly(ethylcne glycol) phenyl ether (meth)acrylates, poly(propylene/ethylene glycol) alkyl ether (meth) acrylates and mixtures thereof. Preferred poly(alkylene oxide) monomers include trimethoylolpropane ethoxylate tri (meth)acrylate, trimethoylolpropane propoxylate tri(meth)acrylate, poly(propylene glycol) methyl ether acrylate, and the like. Particularly suitable poly(propylene glycol) methyl ether acrylate monomers are those having a molecular weight in the range of from about 200 to about 2000. The poly(ethylene oxide/propylene oxide) monomers useful in the present invention may be linear, block or graft copolymers. Such monomers typically have a degree of polymerization of from about 1 to about 50, and preferably from about 2 to about 50.

Typically, the amount of poly(alkylene oxide) monomers useful in the porogens of the present invention is from about 1 to about 99 %wt, based on the total weight of the monomers used. The amount of poly(alkylene oxide) monomers is preferably from about 2 to about 90 %wt, and more preferably from about 5 to about 80 %wt.

The silyl containing monomers and the poly(alkylene oxide) monomers may be used either alone or in combination to form the porogens of the present invention. It is preferred that the silyl containing monomers and the poly (alkylene oxide) monomers are used in combination. In general, the amount of the silyl containing monomers or the poly(alkylene oxide) monomers needed to compatiblize the porogen with the dielectric matrix depends upon the level of porogen loading desired in the matrix, the particular composition of the organo polysilica dielectric matrix, and the composition of the porogen polymer. When a combination of silyl containing monomers and the poly(alkylene oxide) monomers is used, the amount of one monomer may be decreased as the amount of the other monomer is increased. Thus, as the amount of the silyl containing monomer is increased in the combination, the amount of the poly(alkylene oxide) monomer in the combination may be decreased.

The polymers useful as porogens in the present invention may be prepared by a variety of polymerization techniques, such as solution polymerization or emulsion polymerization, and preferably by solution polymerization. The solution polymers useful in the present invention may be linear, branched or grafted and may be copolymers or homopolymers. Particularly suitable solution polymers include cross-linked copolymers. Typically, the molecular weight of the porogen polymers is in the range of 5,000 to 1,000,000, preferably 10,000 to 500,000, and more preferably 10,000 to 100,000. The particle size polydispersity of the porogen polymer particles is in the range of 1 to 20, preferably 1.001 to 15, and more preferably 1.001 to 10.

The solution polymers of the present invention are generally prepared in a non-aqueous solvent. Suitable solvents for such polymerizations are well known to those skilled in the art. Examples of such solvents include, but are not limited to: hydrocarbons, such as alkanes, fluorinated hydrocarbons, and aromatic hydrocarbons, ethers, ketones, esters, alcohols and mixtures thereof. Particularly suitable solvents include dodecane, mesitylene, xylenes, diphenyl ether, gamma-butyrolactone, ethyl lactate, propyleneglycol monomethyl ether acetate, caprolactone, 2-hepatanone, methylisobutyl ketone, diisobutylketone, propyleneglycol monomethyl ether, decanol, and t-butanol.

The solution polymers of the present invention may be prepared by a variety of methods, such as those disclosed in US Patent No. 5,863,996 (Graham) and European Patent Application 1 088 848 (Allen et al.). The emulsion polymers useful in the present invention are generally prepared the methods described in European Patent Application 1 088 848 (Allen et al.).

It is preferred that the polymers of the present invention are prepared using anionic polymerization or free radical polymerization techniques. It is also preferred that the polymers useful in the present invention are not prepared by step-growth polymerization processes.

The polymer particle porogcns of the present invention include cross-linked polymer chains. Any amount of cross-linker is suitable for use in the present invention. Typically, the porogens of the present invention contain at least 1% by weight, based on the weight of the porogen, of cross-linker. Up to and including 100% cross-linking agent, based on the weight of the porogen, may be effectively used in the particles of the present invention. It is preferred that the amount of cross-linker is from about 1% to about 80%, and more preferably from about 1% to about 60%. It will be appreciated by those skilled in the art that as the amount of cross-linker in the porogen increases, the conditions for removal of the porogen from the dielectric matrix may change.

Suitable cross-linkers useful in the present invention include di-, tri-, tetra-, or higher multi-functional ethylenically unsaturated monomers. Examples of cross-linkers useful in the present invention include, but are not limited to: trivinylbenzene, divinyltoluene, divinylpyridine, divinylnaphthalene and divinylxylene; and such as ethyleneglycol diacrylate, trimethylolpropane triacrylate, diethyleneglycol divinyl ether, trivinylcyclohexane, allyl methacrylate ("ALMA"), ethyleneglycol dimethacrylate ("EGDMA"), diethyleneglycol dimethacrylate ("DEGDMA"), propyleneglycol dimethacrylate, propyleneglycol diacrylate, trimethylolpropane trimethacrylate ("TMPTMA"), divinyl benzene ("DVB"), glycidyl methacrylate, 2,2-dimethylpropane 1,3 diacrylate, 1,3-butylene glycol diacrylate, 1,3-butylene glycol dimethacrylate, 1,4-butanediol diacrylate, diethylene glycol diacrylate, diethylene glycol dimethacrylate, 1,6-hexanediol diacrylate, 1,6-hexanediol dimethacrylate, tripropylene glycol diacrylate, triethylene glycol dimethacrylate, tetraethylene glycol diacrylate, polyethylene glycol 200 diacrylate, tetraethylene glycol dimethacrylate, polyethylene glycol dimethacrylate, ethoxylated bisphenol A diacrylate, ethoxylated bisphenol A dimethacrylate, polyethylene glycol 600 dimethacrylate, poly(butanediol) diacrylate, pentaerythritol triacrylate, trimethylolpropane triethoxy triacrylate, glyceryl propoxy triacrylate, pentaerythritol tetraacrylate, pentaerythritol tetramethacrylate, dipentaecrythritol monohydroxypentaacrylate, and mixtures thereof. Silyl containing monomers that are capable of undergoing cross-linking may also be used as cross-linkers, such as, but not limited to, divinylsilane, trivinylsilane, dimethyldivinylsilane, divinylmethylsilane, methyltrivinylsilane, diphenyldivinylsilane, divinylphenylsilane, trivinylphenylsilane, divinylmethylphenylsilane, tetravinylsilane, dimethylvinyldisiloxane, poly(methylvinylsiloxane), poly(vinylhydrosiloxane), poly(phenylvinylsiloxane), tetraallylsilane, 1,3-dimethyl tetravinyldisiloxane, 1,3-divinyl tetramethyldisiloxane and mixtures thereof.

The porogen particles of the present invention may be directly added to the B-staged dielectric matrix material as is or may be first purified to remove impurities that might effect the electrical or physical properties of electronic devices. Purification of the porogen particles may be accomplished either by precipitation of the porogen particles or adsorption of the impurities.

To be useful as porogens in forming porous dielectric materials, the porogens of the present invention must be at least partially removable under conditions which do not adversely affect the dielectric matrix material, preferably substantially removable, and more preferably completely removable. By "removable" is meant that the polymer depolymerizes or otherwise breaks down into volatile components or fragments which are then removed from, or migrate out of, the dielectric material yielding pores or voids. Any procedures or conditions which at least partially remove the porogen without adversely affecting the dielectric matrix material may be used. It is preferred that the porogen is substantially removed. Typical methods of removal include, but are not limited to, chemical, exposure to heat or exposure to radiation, such as, but not limited to, UV, x-ray, gamma ray, alpha particles, neutron beam or electron beam. It is preferred that the matrix material is exposed to heat or UV light to remove the porogen.

The porogens of the present invention can be thermally removed under vacuum, nitrogen, argon, mixtures of nitrogen and hydrogen, such as forming gas, or other inert or reducing atmosphere. The porogens of the present invention may be removed at any temperature that is higher than the thermal curing temperature and lower than the thermal decomposition temperature of the organo polysilica dielectric matrix material. Typically, the porogens of the present invention may be removed at temperatures in the range of 150° to 500° C and preferably in the range of 250° to 425° C. Typically, the porogens of the present invention are removed upon heating for a period of time in the range of 1 to 120 minutes. An advantage of the porogens of the present invention is that 0 to 20% by weight of the porogen remains after removal from the organo polysilica dielectric matrix material.

In one embodiment, when a porogen of the present invention is removed by exposure to radiation, the porogen polymer is typically exposed under an inert atmosphere, such as nitrogen, to a radiation source, such as, but not limited to, visible or ultraviolet light. The porogen fragments generated from such exposure are removed from the matrix material under a flow of inert gas. The energy flux of the radiation must be sufficiently high to generate a sufficient number of free radicals such that porogen particle is at least partially removed. It will be appreciated by those skilled in the art that a combination of heat and radiation may be used to remove the porogens of the present invention.

In preparing the dielectric matrix materials of the present invention, a plurality of porogen particles described above are first dispersed within, or dissolved in, a B-staged dielectric material. Any amount of porogen may be combined with the B-staged dielectric materials according to the present invention. The amount of porogen used will depend on the particular porogen employed, the particular B-staged dielectric material employed, the extent of dielectric constant reduction desired in the resulting porous dielectric material, i.e. the particular porosity desired, and the mean pore size of the porogen particles. Typically, the amount of porogen used is in the range of from 30 to 50 wt%, based on the weight of the B-staged dielectric material, preferably from 30 to 45 wt%, and more preferably from 30 to 40 wt%. A particularly useful amount of porogen is in the range of form about 30 to about 35 wt%.

The porogens of the present invention may be combined with the B-staged dielectric material by any methods known in the art. Typically, the B-staged dielectric material is first dissolved in a suitable high boiling solvent, such as, but not limited to, methyl isobutyl ketone, diisobutyl ketone, 2-heptanone, γ-butyrolactone, ε-caprolactone, ethyl lactate propyleneglycol monomethyl ether acetate, propyleneglycol monomethyl ether, diphenyl ether, anisole, n-amyl acetate, n-butyl acetate, cyclohexanone, N-methyl-2-pyrrolidone, N,N'-dimethylpropyleneurea, mesitylene, xylenes, or mixtures thereof, to form a solution. The porogen particles are then dispersed or dissolved within the solution. The resulting dispersion is then deposited on a substrate by methods known in the art, such as spin coating, spray coating or doctor blading, to form a film or layer.

After being deposited on a substrate, the B-staged dielectric material is then substantially cured to form a rigid, cross-linked dielectric matrix material without substantially removing the porogen particles. The curing of the dielectric material may be by any means known in the art including, but not limited to, heating to induce condensation or e-beam irradiation to facilitate free radical coupling of the oligomer or monomer units. Typically, the B-staged material is cured by heating at an elevated temperature, e.g. either directly, e.g. heated at a constant temperature such as on a hot plate, or in a step-wise manner. Typically, the dielectric material containing polymeric porogens is first annealed at a temperature of from about 200° to about 350° C, and then heated to a higher temperature, such as from about 400° to about 450° C to at least partially remove the porogens. Such curing conditions are known to those skilled in the art.

Once the B-staged dielectric material is cured, the film is subjected to conditions which remove the porogen without substantially degrading the organo polysilica dielectric matrix material, that is, less than 5% by weight of the dielectric matrix material is lost. Typically, such conditions include exposing the film to heat and/or radiation. It is preferred that the matrix material is exposed to heat or light to remove the porogen. To remove the porogen thermally, the dielectric matrix material can be heated by oven heating or microwave heating. Under typical thermal removal conditions, the polymerized dielectric matrix material is heated to about 350° to 400° C. It will be recognized by those skilled in the art that the particular removal temperature of a thermally labile porogen will vary according to composition of the porogen. Upon removal, the porogen polymer depolymerizes or otherwise breaks down into volatile components or fragments which are then removed from, or migrate out of, the dielectric matrix material yielding pores or voids, which fill up with the carrier gas used in the process. Thus, a porous dielectric material having voids is obtained, where the size of the voids is substantially the same as the particle size of the porogen. By "substantially the same" it is meant that the diameter of the pores is within 10% of the mean particle size of the porogens used. The resulting dielectric material having voids thus has a lower dielectric constant than such material without such voids.

The present invention provides a method of manufacturing a porous dielectric material suitable for use in electronic device manufacture including the steps of: a) dispersing a plurality of removable polymeric porogen particles in a B-staged dielectric material, b) curing the B-staged dielectric material to form a dielectric matrix material without substantially degrading the porogen particles; c) subjecting the dielectric matrix material to conditions which at least partially remove the porogen to form a porous dielectric material without substantially degrading the dielectric material; wherein the porogen is substantially compatible with the B-staged dielectric material; wherein the dielectrze material is $\geq$ 30% porous; and wherein the mean particle size of the plurality of porogen particles is selected to provide a closed cell pore structure. Also provided by the present invention is a method of manufacturing a porous organo polysilica dielectric material suitable for use in electronic device manufacture including the steps of: a) dispersing a plurality of removable polymeric porogen particles in a B-staged organo polysilica dielectric material, b) curing the B-staged organo polysilica dielectric material to form a dielectric matrix material without substantially degrading the porogen particles; c) subjecting the organo polysilica dielectric matrix material to conditions which at least partially remove the porogen to form a porous dielectric material without substantially degrading the organo polysilica dielectric material; wherein the porogen is substantially compatible with the B-staged organo polysilica dielectric material and wherein the porogen includes as polymerized units at least one compound selected from silyl containing monomers or poly(alkylene oxide) monomers; wherein the dielectric material is $\geq$ 30% porous; and wherein the mean particle size of the plurality of porogen particles is selected to provide a closed cell pore structure.

A further advantage of the present invention is that low dielectric constant materials are obtained having uniformly dispersed voids, a higher volume of voids than known dielectric materials and/or smaller void sizes than known dielectric materials. The resulting porous dielectric matrix material has low stress, low dielectric constant, low refractive index, improved toughness and improved compliance during mechanical contacting to require less contact force during compression.

The porous dielectric material made by the process of the present invention is suitable for use in any application where a low refractive index or low dielectric material may be used. When the porous dielectric material of the present invention is a thin film, it is useful as insulators, anti-reflective coatings, sound barriers, thermal breaks, insulation, optical coatings and the like. The porous dielectric materials of the present invention are preferably useful in electronic and optoelectronic devices including, but not limited to, the fabrication of multilevel integrated circuits, e.g. microprocessors, digital signal processors, memory chips and band pass filters, thereby increasing their performance and reducing their cost.

The porous dielectric matrix materials of the present invention are particularly suitable for use in integrated circuit manufacture. In one embodiment of integrated circuit manufacture, as a first step, a layer of a composition including B-staged dielectric material having a polymeric porogen dispersed or dissolved therein and optionally a solvent is deposited on a substrate. Suitable deposition methods include spin casting, spray casting and doctor blading. Suitable optional solvents include, but are not limited to: methyl isobutyl ketone, diisobutyl ketone, 2-heptanone, $\gamma$-butyrolactone, $\varepsilon$-caprolactone, ethyl lactate propyleneglycol monomethyl ether acetate, propyleneglycol monomethyl ether, diphenyl ether, anisole, n-amyl acetate, n-butyl acetate, cyclohexanone, N-methyl-2-pyrrolidone, N,N'-dimethylpropyleneurea, mesitylene, xylenes or mixtures thereof. Suitable substrates include, but are not limited to: silicon, silicon dioxide, silicon oxycarbide, silicon germanium, silicon-on-insulator, glass, silicon nitride, ceramics, aluminum, copper, gallium arsenide, plastics, such as polycarbonate, circuit boards, such as FR-4 and polyimide, and hybrid circuit substrates, such as aluminum nitride-alumina. Such substrates may further include thin films deposited thereon, such films including, but not limited to: metal nitrides, metal carbides, metal silicides, metal oxides, and mixtures thereof. In a multilayer integrated circuit device, an underlying layer of insulated, planarized circuit lines can also function as a substrate.

In a second step in the manufacture of integrated circuits, the layer of the composition is heated to an elevated temperature to cure the B-staged dielectric material to form a dielectric matrix material without degrading the polymeric porogen. A catalyst, such as a Brønsted or Lewis base or Brønsted or Lewis acid, may also be used. In a third step, the resulting cured organo polysilica dielectric matrix material is then subjected to conditions such that the porogen contained therein is substantially removed without adversely affecting the dielectric matrix material to yield a porous organo polysilica dielectric material.

The porous dielectric material is then lithographically patterned to form vias and/or trenches in subsequent processing steps. The trenches generally extend to the substrate and connect to at least one metallic via. Typically, lithographic patterning involves (i) coating the dielectric material layer with a positive or negative photoresist, such as those marketed by Shipley Company (Marlborough, MA); (ii) imagewise exposing, through a mask, the photoresist to radiation, such as light of appropriate wavelength or e-beam; (iii) developing the image in the resist, e.g., with a suitable developer; and (iv) transferring the image through the dielectric layer to the substrate with a suitable transfer technique such as reactive ion beam etching. Optionally, an antireflective composition may be disposed on the dielectric material prior to the photoresist coating. Such lithographic patterning techniques are well known to those skilled in the art.

A metallic film is then deposited onto the patterned dielectric layer to fill the trenches. Preferred metallic materials include, but are not limited to: copper, tungsten, gold, silver, aluminum or alloys thereof. The metal is typically deposited onto the patterned dielectric layer by techniques well known to those skilled in the art. Such techniques include, but are not limited to: chemical vapor deposition ("CVD"), plasma-enhanced CVD, combustion CVD ("CCVD"), electro and electroless deposition, sputtering, or the like. Optionally, a metallic liner, such as a layer of nickel, tantalum, titanium, tungsten, or chromium, including nitrides or silicides thereof, or other layers such as barrier or adhesion layers, e.g. silicon nitride or titanium nitride, is deposited on the patterned and etched dielectric material.

In a fifth step of the process for integrated circuit manufacture, excess metallic material is removed, e.g. by planarizing the metallic film, so that the resulting metallic material is generally level with the patterned dielectric layer. Planarization is typically accomplished with chemical/mechanical polishing or selective wet or dry etching. Such planarization methods are well known to those skilled in the art.

It will be appreciated by those skilled in the art that multiple layers of dielectric material, including multiple layers of organo polysilica dielectric material, and metal layers may subsequently be applied by repeating the above steps. It will be further appreciated by those skilled in the art that the compositions of the present invention are useful in any and all methods of integrated circuit manufacture.

Thus, the present invention provides a method of preparing an integrated circuit with a closed cell porous film including the steps of: a) depositing on a substrate a layer of a composition including B-staged dielectric material having a plurality of polymeric porogens dispersed therein; b) curing the B-staged dielectric material to form a dielectric matrix material without substantially removing the porogens; c) subjecting the dielectric matrix material to conditions which at least partially remove the porogens to form a porous dielectric material layer without substantially degrading the dielectric material; d) patterning the porous dielectric layer; c) depositing a metallic film onto the patterned porous dielectric layer; and f) planarizing the film to form an integrated circuit; wherein the porogen is substantially compatible with the B-staged dielectric material; and wherein the dielectric material is $\geq 30\%$ porous; and wherein the mean particle size of the porogens is selected to provide a closed cell pore structure.

It is preferred that the dielectric material is an organo polysilica material. Thus, the present invention also provides a method of preparing an integrated circuit with a closed cell porous film including the steps of: a) depositing on a substrate a layer of a composition including B-staged organo polysilica dielectric material having polymeric porogen dispersed therein; b) curing the B-staged organo polysilica dielectric material to form an organo polysilica dielectric matrix material without substantially removing the porogen; c) subjecting the organo polysilica dielectric matrix material to conditions which at least partially remove the porogen to form a porous organo polysilica dielectric material layer without substantially degrading the organo polysilica dielectric material; d) patterning the porous dielectric layer; c) depositing a metallic film onto the patterned porous dielectric layer; and f) planarizing the film to form an integrated circuit; wherein the porogen is substantially compatible with the B-staged organo polysilica dielectric material and wherein the porogen includes as polymerized units at least one compound selected from silyl containing monomers or poly(alkylene oxide) monomers; and wherein the dielectric material is $\geq 30\%$ porous.

Also included in the present invention is an integrated circuit including a porous dielectric material wherein the porous dielectric material $\geq 30\%$ porous; wherein the pores are substantially non-interconnected; and wherein the mean particle size of the pores is selected to provide a closed cell pore structure. It is preferred that the porous dielectric material is an organo polysilica material, and more preferably methylsilsesquioxane. It is further preferred that the dielectric material has a porosity $\geq 35\%$.

A still further advantage provided by the close cell pore structure of the present porous dielectric materials is that a cap layer for the porous dielectric layer is not needed. Such cap layers are typically applied directly to the porous dielectric layer and act as a barrier preventing intrusion for the next applied layer into the pores of the dielectric material. Thus, the present invention provides an electronic device including a porous dielectric layer free of an added cap layer/ wherein the porous dielectric layer has $\geq 30\%$ porosity.

The following examples are presented to illustrate further various aspects of the present invention, but are not intended to limit the scope of the invention in any aspect.

Example 1

A methyl silsesquioxane ("MeSQ") sample is prepared by combining a methyl silsesquioxane resin (0.80 g), with a plurality of porogen particles having as polymerized units PEGMEMA475/VTMOS/TMPTMA (80/10/10) in propylene glycol methyl ether acetate (1.33 g, 15 wt%) and propylene glycol methyl ether acetate (1.43 g). The mean particle size of the plurality of porogen particles is varied. The sample is deposited on a silicon wafer as a thin coating using spin casting. The thickness (estimated at $\sim 1.1$ μm) of the film is controlled by the duration and spin rate of spread cycle, drying cycle and final spin cycle. The wafer is processed at 150° C for 1 minute followed by heating in a PYREX™ container in an oven to 200° C under an argon atmosphere. The oxygen content of the container is monitored and is maintained below 5 ppm before heating of the sample. After 30 minutes at 200° C, the furnace is heated at a rate of 10° C per minute to a temperature of 420° C and is held for 60 minutes. The decomposition of the polymer particle is accomplished at this temperature without expansion of the polymer.

The above procedure is repeated using various levels of porogen.

Example 2

A sample is prepared by combining benzocyclobutene ("BCB") "B-staged" matrix polymer, available from Dow Chemical Company, Midland, Michigan (0.80 g), mesitylene (1.43 g), and a plurality of porogen particles having as polymerized units VAS/STYRNE/TMPTMA (80/10/10) in cyclohcxanonc (1.33 g, 15 wt%). The mean particle size of the plurality of porogen particles is varied. The sample is deposited on a silicon wafer as a thin coating using spin casting. The thickness (estimated at $\sim$ 1.1 $\mu$m) of the film is controlled by the duration and spin rate of spread cycle, drying cycle and final spin cycle. The wafer is processed at 150° C for 1 minute followed by heating in a PYREX™ container in an oven to 350° C under an argon atmosphere. The oxygen content of the container is monitored and is maintained below 5 ppm before heating of the sample. After 30 minutes at 250° C, the furnace is heated at a rate of 10° C per minute to a temperature of 350° C and is held for 60 minutes. The decomposition of the polymer particle is accomplished at this temperature without expansion of the polymer.
The above procedure is repeated using various levels of porogen.

Example 3

The procedure of Example 2 is repeated except that the polyarylene ether "B-staged" matrix polymer is available under the SILK tradename from Dow Chemical Company and cyclohexane is used as the solvent. The procedure is repeated using various levels of porogen. With the following changes to the thermal history to accommodate the new matrix material: after 30 minutes at 350° C, the furnace is heated at a rate of 10° C per minute to a temperature of 420° C and is held for 60 minutes. The decomposition of the polymer particle is accomplished at this temperature without expansion of the polymer.

Example 4

The procedure of Example 3 is repeated except that the polyarylene ether "B-staged" matrix polymer is available under the FLARE tradename from Honeywell Electronic Materials, Morristown, New Jersey, The procedure is repeated using various levels of porogen.

Example 5

The procedure of Example 3 is repeated except that the polyarylene ether "B-staged" matrix polymer is available under the VELOX tradename from Air Products, Allentown, Pennsylvania. The procedure is repeated using various levels of porogen

Example 6

The wall thickness of the resulting porous dielectric samples from Examples 1 to 6 is then calculated to determine the extent of pore interconnectivity. Such calculations are performed according to the following formula: wall thickness is the difference between unit cell length and the diameter of a porogen particle, where the unit cell length is equal to the cube root of the volume of porogen particle divided by the total pore volume. Wall thickness of 0.5 nm or greater are required to maintain a closed cell pore structure. The results are reported in Table 1.

Table 1

| Porogen Loading Level (%) | Porogen Particle Size (nm) | Calculated Wall Thickness (nm) | Interconnectivity |
| --- | --- | --- | --- |
| 20 | 1 | 0.38 | Open Cell |
| 20 | 1.5 | 0.57 | Close Cell |
| 20 | 2 | 0.76 | Close Cell |
| 30 | 2.5 | 0.41 | Open Cell |
| 30 | 3.0 | 0.51 | Close Cell |
| 30 | 3.5 | 0.61 | Close Cell |
| 35 | 3 | 0.43 | Open Cell |
| 35 | 3.5 | 0.50 | Close Cell |
| 35 | 4 | 0.57 | Close Cell |
| 40 | 5 | 0.47 | Open Cell |
| 40 | 6 | 0.56 | Close Cell |

Table 1 (continued)

| Porogen Loading Level (%) | Porogen Particle Size (nm) | Calculated Wall Thickness (nm) | Interconnectivity |
|---|---|---|---|
| 40 | 7 | 0.66 | Close Cell |
| 45 | 9 | 0.47 | Open Cell |
| 45 | 10 | 0.52 | Close Cell |
| 45 1 | 1 | 0.57 | Close Cell |

Example 7

The procedure of Example 1 is repeated using a plurality of porogen particles having a mean particle size of 3,5 nm.

Example 8

The interconnectivity of the porous films from Example 7 are measured by placing a PYREX™ glass ball joint complete with a rubber o-ring against the thin, porous dielectric layer deposited onto a conductive silicon wafer, having a resistivity ("R") = <0.02 Ohm-cm. The ball joint is held in place by a clamp and then an aqueous 10,000 ppm of copper (as copper nitrate) ICP standard solution in 5% nitric acid is charged into the ball joint. A platinum electrode is placed into the solution and then a second reference electrode is also inserted into the solution. The back side of the wafer, i.e. the side opposite the film, is also contacted with an electrode. A measuring or monitoring system is used to record the impedence spectra with a Solartron 1260 Gain/Phase Analyzer, EG&G Princeton Applied Research (PAR) 273 potentiostat/Galvanostat, and Zplot Impedance Software (available from Scribner Associates). Individual data files are fit to a modified Randles circuit, (Zsim Impedance software from Scribner Associates), and their impedance parameters are plotted and compared as a function of time.

The copper ICP standard solution is allowed to remain in contact with the film for 24 hours and the impedance is measured again. These values are compared to those for a non-porous film, Differences in conductivity values of less than 1 indicate closed cell pore structures. Differences in conductivity values of greater than 1 indicate open cell pore structures.

| Experimental parameters: | |
|---|---|
| Frequency range | 100 KHz to 0.5 Hz |
| Sine wave amplitude | 10mV |
| DC Potential | 1 volt |
| Points/decade | 5 |

The porous films of Example 7 are analyzed using this electrochemical test. For each sample film, the impedance value is reduced to the resistance which is then normalized for each of the films by dividing by the film thickness. The results are reported in Table 2.

Table 2

| Porogen Loading (%) | Conductivity (S/m) | Interconnectivily |
|---|---|---|
| 0 | 0.017 | Close Cell |
| 20 | 0.214 | Close Cell |
| 22 | 0.205 | Close Cell |
| 24 | 0.159 | Close Cell |
| 26 | 0.298 | Close Cell |
| 28 | 0.136 | Close Cell |
| 30 | 0.543 | Close Cell |
| 35 | 0.439 | Close Cell |
| 40 | 1.771 | Open Cell |

From these data, it can be seen that when a 3.5 nm particle is used, closed cell pore structures having between 35 and 40% porosity can be obtained.

**Claims**

1. A closed cell porous dielectric material suitable for use in electronic device manufacture, the porous dielectric material having a plurality of pores and having greater than or equal to 30% porosity.

2. The closed cell porous dielectric material of claim 1 wherein the dielectric material is selected from inorganic matrix materials such as carbides, oxides, nitrides and oxyfluorides of silicon, boron, or aluminum; silicones; siloxanes; organo polysilica materials; silicates; silazanes; benzocyclobutenes, poly(aryl esters), poly(ether ketones), polycarbonates, polyimides, fluorinated polyimides, polynorbornenes, poly(arylene ethers), polyaromatic hydrocarbons, polyquinoxalines, poly(perfluorinated hydrocarbons) and polybenzoxazoles.

3. The closed cell porous dielectric material of any one of claims 1 to 2 wherein the dielectric material comprises hydrogen silsesquioxane.

4. The closed cell porous dielectric material of any one of claims 1 to 3 wherein the plurality of pores has a mean particle size of 3 nm or greater and the porosity is $\geq$ 35%.

5. The closed cell porous dielectric material of any one of claims 1 to 4 wherein the plurality of pores has a mean particle size of greater than 5 nm and the porosity is $\geq$ 40%.

6. A method of manufacturing a porous dielectric material suitable for use in electronic device manufacture comprising the steps of: a) dispersing a plurality of removable polymeric porogen particles in a B-staged dielectric material, b) curing the B-staged dielectric material to form a dielectric matrix material without substantially degrading the porogen particles; c) subjecting the dielectric matrix material to conditions which at least partially remove the porogen to form a porous dielectric material without substantially degrading the dielectric material; wherein the porogen is substantially compatible with the B-staged dielectric material; wherein the dielectric material is $\geq$ 30% porous; and wherein the mean particle size of the plurality of porogen particles is selected to provide a closed cell pore structure.

7. A method of manufacturing a porous organo polysilica dielectric material suitable for use in electronic device manufacture comprising the steps of: a) dispersing a plurality of removable polymeric porogen particles in a B-staged organo polysilica dielectric material, b) curing the B-staged organo polysilica dielectric material to form a dielectric matrix material without substantially degrading the porogen particles; c) subjecting the organo polysilica dielectric matrix material to conditions which at least partially remove the porogen to form a porous dielectric material without substantially degrading the organo polysilica dielectric material; wherein the porogen is substantially compatible with the B-staged organo polysilica dielectric material and wherein the porogen comprises as polymerized units at least one compound selected from silyl containing monomers or poly(alkylene oxide) monomers; wherein the dielectric material is $\geq$ 30% porous; and wherein the mean particle size of the plurality of porogen particles is selected to provide a closed cell pore structure.

8. A method of preparing an integrated circuit with a closed cell porous film comprising the steps of: a) depositing on a substrate a layer of a composition including B-staged dielectric material having a plurality of polymeric porogens dispersed therein; b) curing the B-staged dielectric material to form a dielectric matrix material without substantially removing the porogens; c) subjecting the dielectric matrix material to conditions which at least partially remove the porogens to form a porous dielectric material layer without substantially degrading the dielectric material; d) patterning the porous dielectric layer; e) depositing a metallic film onto the patterned porous dielectric layer; and f) planarizing the film to form an integrated circuit; wherein the porogen is substantially compatible with the B-staged dielectric material; and wherein the dielectric material is $\geq$ 30% porous; and wherein the mean particle size of the porogens is selected to provide a closed cell pore structure.

9. An integrated circuit comprising a porous dielectric material wherein the porous dielectric material is $\geq$ 30% porous; wherein the pores are substantially non-interconnected; and wherein the mean particle size of the pores is selected to provide a closed cell pore structure.

10. An electronic device including a porous dielectric layer free of an added cap layer, wherein the porous dielectric layer has ≥ 30% porosity

FIG. 1

FIG. 2

**European Patent Office**

## EUROPEAN SEARCH REPORT

Application Number

EP 02 25 3445

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| P,X | EP 1 172 823 A (SHIPLEY COMPANY LLC) 16 January 2002 (2002-01-16) * claims 1-23; example 2 * | 1-10 | H01B3/46 C08J9/26 H01L21/312 H01L21/768 |
| X | EP 1 088 848 A (SHIPLEY COMPANY LLC) 4 April 2001 (2001-04-04) * claims 1-29; examples 9-11 * | 1-10 | C08J9/02 C08L83/04 H01L21/316 C09D183/04 |
| X | PATENT ABSTRACTS OF JAPAN vol. 2000, no. 02, 29 February 2000 (2000-02-29) & JP 11 322992 A (JSR CORP), 26 November 1999 (1999-11-26) * abstract * | 1-10 | |
| X | WO 00 61834 A (ALLIED SIGNAL INC) 19 October 2000 (2000-10-19) * page 17, line 28 - page 18, line 5; claims; example 9 * | 1-10 | |
| X | WO 00 31183 A (DOW CHEMICAL CO) 2 June 2000 (2000-06-02) * page 13, line 13 - page 15, line 26; claims 1-36 * | 1-10 | TECHNICAL FIELDS SEARCHED (Int.Cl.7) C08J H01B H01L |
| A | EP 1 035 183 A (CATALYSTS & CHEM IND CO) 13 September 2000 (2000-09-13) * claims; table 1 * | 1-10 | C08L C09D |
| A | WO 00 05297 A (MINAMI KAZUHIKO ;KOBAYASHI MITSUAKI (JP); MINNESOTA MINING & MFG ()) 3 February 2000 (2000-02-03) * page 4, line 5 - line 12; page 11, line 5 - line 9; claims * | 1-10 | |
| A | US 5 548 159 A (JENG SHIN-PUU) 20 August 1996 (1996-08-20) * claims 1-18; figures 8,9 * | 1-10 | |

The present search report has been drawn up for all claims

| Place of search | Date of completion of the search | Examiner |
|---|---|---|
| THE HAGUE | 8 August 2002 | Lehnert, A |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
 
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 02 25 3445

This annex lists the patent family members relating to the patent documents cited in the above-mentioned European search report.
The members are as contained in the European Patent Office EDP file on
The European Patent Office is in no way liable for these particulars which are merely given for the purpose of information.

08-08-2002

| Patent document cited in search report | | Publication date | Patent family member(s) | | Publication date |
|---|---|---|---|---|---|
| EP 1172823 | A | 16-01-2002 | US | 6271273 B1 | 07-08-2001 |
| | | | CN | 1347932 A | 08-05-2002 |
| | | | EP | 1172823 A1 | 16-01-2002 |
| | | | JP | 2002037912 A | 06-02-2002 |
| | | | US | 2002012875 A1 | 31-01-2002 |
| EP 1088848 | A | 04-04-2001 | US | 6420441 B1 | 16-07-2002 |
| | | | CN | 1297963 A | 06-06-2001 |
| | | | EP | 1088848 A1 | 04-04-2001 |
| | | | JP | 2001210142 A | 03-08-2001 |
| JP 11322992 | A | 26-11-1999 | NONE | | |
| WO 0061834 | A | 19-10-2000 | US | 6204202 B1 | 20-03-2001 |
| | | | US | 6413882 B1 | 02-07-2002 |
| | | | AU | 4462400 A | 14-11-2000 |
| | | | CN | 1355858 T | 26-06-2002 |
| | | | EP | 1169491 A1 | 09-01-2002 |
| | | | WO | 0061834 A1 | 19-10-2000 |
| WO 0031183 | A | 02-06-2000 | CN | 1328589 T | 26-12-2001 |
| | | | EP | 1141128 A1 | 10-10-2001 |
| | | | WO | 0031183 A1 | 02-06-2000 |
| EP 1035183 | A | 13-09-2000 | EP | 1035183 A1 | 13-09-2000 |
| | | | WO | 0018847 A1 | 06-04-2000 |
| WO 0005297 | A | 03-02-2000 | JP | 2000044719 A | 15-02-2000 |
| | | | AU | 5106899 A | 14-02-2000 |
| | | | EP | 1098928 A1 | 16-05-2001 |
| | | | WO | 0005297 A1 | 03-02-2000 |
| | | | US | 6426372 B1 | 30-07-2002 |
| US 5548159 | A | 20-08-1996 | US | 5527737 A | 18-06-1996 |
| | | | EP | 0701277 A2 | 13-03-1996 |
| | | | JP | 8064679 A | 08-03-1996 |
| | | | US | 5858871 A | 12-01-1999 |

EPO FORM P0459

For more details about this annex : see Official Journal of the European Patent Office, No. 12/82